# EUROPÄISCHE PATENTSCHRIFT

(11) **EP 2 014 788 B1**
(45) Veröffentlichungstag und Bekanntmachung des Hinweises auf die Patenterteilung: **19.02.2014**
(21) Anmeldenummer: 08008962.6
(22) Anmeldetag: 15.05.2008
(51) Int. Cl.: C23C 14/34

(54) **Kühlplatte**
Cooling plate
Plaque de refroidissement

(30) Priorität: 04.06.2007 DE 102007026248
(43) Veröffentlichungstag der Anmeldung: 14.01.2009
(73) Patentinhaber: Oerlikon Mechatronics AG, Trübbach, 9477 Trübbach (CH)
(72) Erfinder: Dagorov, Spass, 9439 Balgach (CH)
(74) Vertreter: Kempkens, Anke

(56) Entgegenhaltungen:
- WO-A-98/02597
- DE-A1- 4 015 388
- US-A- 4 297 190
- US-A1- 2006 272 802

## Beschreibung

Die vorliegende Erfindung bezieht sich auf eine Kühlplatte, insbesondere auf eine Kühlplatte zur Anwendung im Vakuum.

### Stand der Technik / Definitionen

Im Stand der Technik sind Kühlplatten z. B. für Sputtertargets, Wafer oder allgemein für Substrate, die durch Wärmeleitung auf bestimmte Temperaturen gebracht oder gehalten werden müssen, bekannt. Ebenso sind Kühlplatten bekannt, die das Prinzip der Wärmestrahlung oder der Konvektion nutzen.

Unter einer Kühlplatte lässt sich also allgemein ein Körper verstehen, der mit seiner Umgebung bzw. einem Substrat Wärmeenergie austauscht. Eine aktive Kühlplatte wird dazu selbst durch Fluide temperiert. Zu einem Kühlsystem im weiteren Sinne können Zu- und Ableitungen zu der Kühlplatte, ein Zirkulationssystem für das Fluid (Kreislauf), Reservoire und Wärmetauscher gehören.

Der Begriff "Kühlplatte" soll im Rahmen vorliegender Erfindung daher nicht einschränkend definiert sein auf die Abfuhr von überschüssiger Wärmeenergie.

Als die Wärmeenergie zu- oder abführendes Fluidum können Gase oder Flüssigkeiten eingesetzt werden. Der nachfolgend häufig gebrauchte technische Begriff Kühlflüssigkeit wird im Zusammenhang mit der vorliegenden Erfindung nicht einschränkend nur für "Kühlung" verwendet, sondern bezieht die vorgenannten anderen Ausführungen bzw. Anwendungen mit ein.

Analoges gilt für Begriff wie Kühlkanal, Kühlfluid, Kühlmedium, Kühlkreislauf etc. Die Verwendung eines dieser Begriffe ist nicht als einseitige Festlegung auf eine spezielle Funktion zu sehen.

Besonderer Augenmerk gilt Kühlplatten, die im Vakuum eingesetzt werden sollen bzw. in Anlagen/Systemen wo eine Kühlplatte als Teil der Wandung zwischen Vakuumbereich und Umgebung zu sehen ist. Daraus ergeben sich besondere Anforderungen in bezug auf Vakuumdichtigkeit bzw. Stabilität, um die durch die Druckdifferenz entstehenden Kräfte ableiten zu können. Dies ist umso wichtiger, als der Wärmeübergang vom Substrat zur Kühlplatte häufig durch direkten Kontakt, durch Verlöten, Verschweissen, Verkleben oder Zusammenspannen hergestellt wird. Verwindungssteifigkeit ist daher ein wichtiges Kriterium.

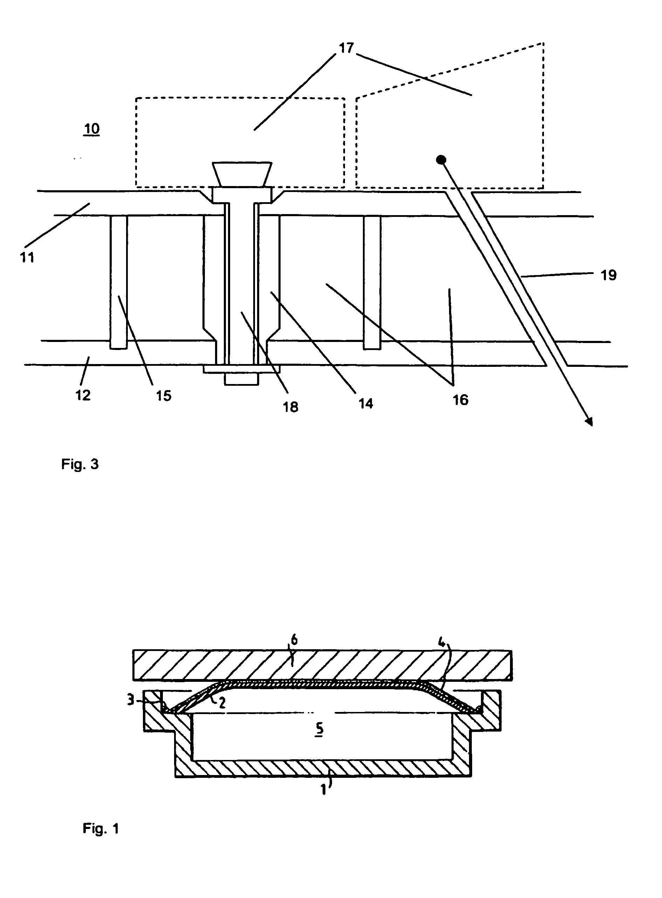

Im Stand der Technik werden Kühlplatten für Vakuumanwendungen meist zumindest zweiteilig ausgeführt, beispielsweise bestehend aus einer massiven Platte, in der Einfräsungen angebracht werden, die als Kanäle / Reservoire für das Kühlfluid dienen und weiter einer Abdeckung über diesen eingefrästen Kanälen, die das System zur Umgebung hin abtrennen. Diese Abtrennung kann, je nach Auslegung, aus einer Metallfolie, aus millimeterdünnem Blech oder wiederum einer massiven Platte bestehen. Von einem Reservoir oder Kreislauf gespeist durchströmt das Kühlfluid die Kanäle und sorgt so für die Zufuhr/Abtransport der Wärmeenergie. Figur 1 zeigt eine solche Kühlplatte gemäss Stand der Technik (DE 40 15 388 A1). Hier umfasst sie eine Platte 1 mit Ausfräsungen, wodurch ein Reservoir 5 für ein Kühlfluid gebildet wird. Die Abtrennung zur Umgebung besteht in diesem Fall aus einer Abdeckung aus zwei Lagen 2 und 4, die mit der Platte 1 im Kontaktbereich 3 verbunden sind. Die Abdeckung befindet sich im Kontakt mit einem Substrat 6, das temperiert wird.

Weitere Ausführungen gemäss Stand der Technik umfassen Kühlrohre, die auf Platten aufgelötet oder geschweisst sind. Diese Rohre können, ähnlich den vorgenannten Kühlkanälen, mäanderförmig oder in Schlaufen ausgeführt werden, um einen möglichst guten Wärmeübergang zu gewährleisten.

### Problemstellung

Den vorbeschriebenen Ausführungsformen im Stand der Technik ist gemein, dass stets ein Kompromiss zwischen Stabilität der Kühlplatte und deren Kühlleistung gefunden werden muss. Der Einsatz massiver Platten und deren Fräsbearbeitung sind zeit- und materialaufwändig, zudem sind diese Konstruktionen relativ schwer.

Es ist daher Aufgabe der vorliegenden Erfindung, eine Kühlplatte zu schaffen, die flexibel bei der Auslegung der Kühlleistung ist, mechanisch hochstabil bei gleichzeitig reduziertem Materialaufwand, einfach in der Herstellung und dem Transport.

### Angabe der Lösung bzw. des Lösungsweges

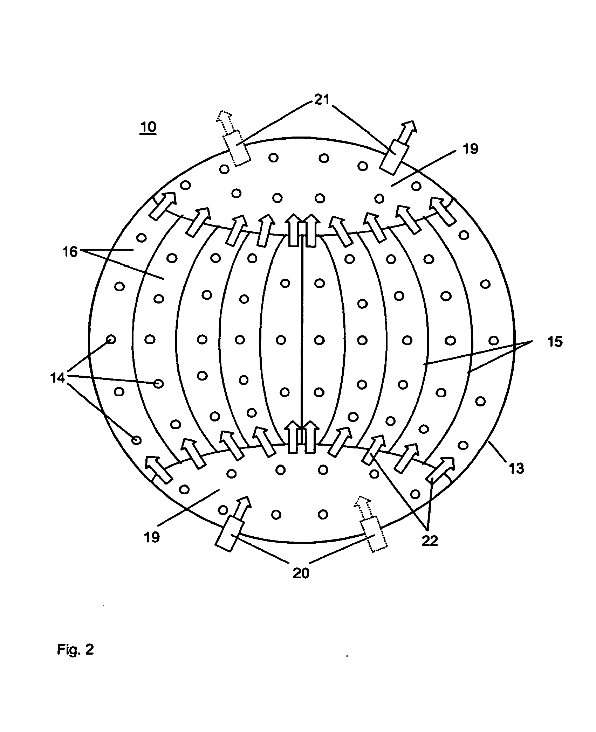

Die vorgenannte Aufgabe wird dadurch gelöst, dass die Funktionen "Stabilität" und "Kühlung" entkoppelt werden. Im Folgenden wird dies unter Bezug auf die Figuren 2 und 3 erläutert. Figur 2 zeigt eine Draufsicht auf eine Kühlplatte und Figur 3 einen Teil eines Querschnitts.

Strukturell besteht die Lösung darin, die Kühlplatte 10 als überwiegenden Hohlkörper auszulegen, bestehend aus einer Bodenplatte 12, Aussenwand (Aussenwänden) 13, einer Deckplatte 11, die einzeln gefertigt werden können und dann verbunden werden. Zwischen Bodenplatte 12 und Deckplatte 11 werden Stützelemente 14 angeordnet, die die mechanische(n) Belastung(en) aufnehmen. Diese werden bevorzugt als runde Einzelstützen in Form von Bolzen oder Hülsen ausgelegt. Ferner werden im Wesentlichen nicht tragende Leitbleche 15 zwischen Bodenplatte 12 und Deckplatte 13 angeordnet, die die Unterteilung des Hohlkörpers / Kühlkörpers 10 in Leitbereiche 16 für das Kühlfluid zulassen. Diese Leitbleche 15 können in Nuten, die in Deck- und/oder Bodenplatte eingefräst werden, gehaltert werden oder als aufgeschweisste Stege realisiert werden. Da diesen Leitblechen 15 keine wesentlich tragende Funktion zukommt, können sie in gewünschte Formen gebogen werden bzw. dünn ausgelegt werden. Da die mechanische Stabilität durch die punktuell angeordneten Stützelemente 14 erreicht wird, können die Leitbleche 15 im Hohlkörper ohne wesentliche Einschränkung angeordnet werden. Die Leitbereiche 16 "führen" somit den Fluidstrom durch den Hohlkörper und erlauben so, den Wärmetransfer zwischen Fluid und Kühlplatte wie gewünscht auszulegen. Auf diese Weise können Totbereiche mit ungenügender Durchströmung vermieden werden, aber auch Bereiche überhöhter Strömung. Dabei müssen die Leitbereiche 16 nicht druckdicht gegeneinander ausgeführt werden, sondern können lediglich trennend zwischen den Bereichen angeordnet werden.

In einer bevorzugten Ausführungsform werden die Stützelemente 15 als Hülsen ausgelegt, so dass ein Substrat 17 durch die Kühlplatte hindurch mit dieser verschraubt werden kann. Eine solche Befestigung ist als Element 18 angedeutet. Durch eine geeignete Anzahl Hülsen kann eine sehr gute Befestigung von Kühlplatte und Substrat erreicht werden.

In der Regel werden diese Hülsen senkrecht zu Boden bzw. Deckplatte angeordnet werden. In einer weiteren Variante können diese Hülsen aber auch unter einem anderen Winkel angeordnet werden, um z. B. auf das Substrat eine gewünschte Kraftkomponente auszuüben, wie mit 19 angedeutet. Dies kann notwendig sein, um gewisse Spannungen des Substrats zu kompensieren, aber auch, um eine Justagemöglichkeit zu schaffen. Letzteres ist insbesondere interessant bei einem segmentierten Substrat.

Eine weitere bevorzugte Ausführungsform verwendet zusätzlich zu den Leitbereichen zwischen den Leitblechen sog. Kollektorbereiche 19. Diese werden bevorzugt dort angelegt, wo das Kühlmedium in die Kühlplatte eintritt 20 bzw. abgeführt wird 21. Ein Kollektorbereich 19 wird durch ein Leitblech realisiert, das einen Teil des Hohlkörpers abtrennt. Dieses Leitblech hat Durchlässe 22 in Form von Bohrungen, Ausstanzungen, Ausnehmungen, die das Kühlfluid in die anderen (Leit-)Bereiche 16 des Hohlkörpers übertreten lassen (in Figur 2 als Pfeile angedeutet). Der Vorteil liegt darin, dass durch die Zahl, Grösse und Formgebung der Durchlässe 22 das Fluid gezielt in bestimmte Leitbereiche geleitet werden kann. So können Strömungsgeschwindigkeiten und Durchflussmengen eingestellt werden. Zudem erlaubt der Kollektorbereich dem in der Regel durch eine Zuführung schnell hereinströmende Fluid, sich zu beruhigen, zu verteilen und eine durch die Einströmrichtung vorgegebene Vorzugsrichtung aufzuheben.

Ein weiterer Kollektorbereich 19 kann um die Ausströmöffnung(en) 21 angeordnet werden mit ähnlichen Vorteilen.

Als Materialien für eine Kühlplatte gemäss vorliegender Erfindung kommen alle Materialien in Frage, die die Kriterien an mechanische Stabilität, Dichtheit und Temperaturbeständigkeit erfüllen. Gebräuchlich, speziell für Vakuumanwendungen sind Metalle wie Stahl, Aluminium, Kupfer oder entsprechende Kunststoffe. Für die Leitbleche 15 bieten sich dünne, biegsame Bleche an, Boden- und Deckplatte können aus üblichem Plattenmaterial gefertigt werden. Eine Ausführungsform kann auch darin bestehen, dass Teile der vorbeschriebenen Erfindung als Feingussteil realisiert werden, wobei die oben beschriebenen Funktionsteile als Elemente des Feingussteils dargestellt werden, z. B. Bodenplatte, Stützelemente und Leitbleche als Gussteil, der Rest wie beschrieben als zusätzliche Elemente.

Durch die flexible Auslegung der Leitbereiche können verschiedene Geometrien von Kühlplatten realisiert werden, sei es rund, rechteckig, quadratisch. Es kann für eine möglichst homogene Kühlleistung gesorgt werden aber auch eine gezielte inhomogene Kühlleistung, um z. B. auf dem Substrat auftretende Spitzenbelastungen gezielt aufzufangen.

Die Anwendung solcher Kühlplatten, vor allem im Vakuum, ist vielfältig. So können Kühlsysteme für Halbleiter-Wafer, ebenso für andere Substrate aus Kunststoff (e. g. CD, DVD) oder Glas (Beschichtung von TFT, Solarzellen, Architekturglas) realisiert werden. Eine weitere Anwendung sind Kühlplatten für PVD-Sputtertargets. Diese Targets können auch segmentiert sein, die vorliegende Erfindung erlaubt eine Befestigung auch solcher Segmente. Eine weitere Anwendung ist die Kühlung von Spiegeln, deren Planlage und Oberflächengeometrie auch bei Beaufschlagung mit energiereicher Strahlung erhalten bleiben soll. Solche Spiegel werden z. B. in Belichtungssystemen für Halbleiterprozesstechnologie eingesetzt oder im Bereich der Lasertechnologie.

Die flexible Auslegung erlaubt vor allem auch, grossflächige Kühlsysteme zu realisieren bis in den Bereich mehrerer Quadratmeter.

Hervorzuheben ist, dass auf sehr einfache Art auch Systeme experimentell ausgelegt werden können. Nach Fertigung des Hohlkörpers können die Leitbleche z. B. lösbar befestigt werden (geheftet, verklebt, verklemmt) und so die Auslegung der Wärmetransferleistung gemessen werden, Strömungsverhalten untersicht und optimiert werden. Wird dazu die Deckplatte aus durchsichtigem Material gefertigt und das Kühlfluid mit sichtbaren Partikeln angereichter, kann optisch die Funktionalität geprüft werden.

### Vorteile der Erfindung

Die Vorteile der erfindungsgemässen Kühlplatte sind somit eine erhöhte Flexibilität, Effizienz bei der Auslegung, Wirtschaftlichkeit bei Herstellung und Transport sowie eine verbesserte Kühlleistung.

### Bezugszeichenliste

- 1: Kühlplatte, Platte
- 2, 4: zweilagige Abdeckung
- 3: Kontaktbereich
- 5: Reservoir
- 6: Substrat
- 10: Kühlplatte, Kühlkörper, Hohlkörper
- 11: Deckplatte
- 12: Bodenplatte
- 13: Aussenwand / Aussenwände
- 14: Stützelement, Einzelstütze, Bolzen, Hülse
- 15: Leitblech(e)
- 16: Leitbereich(e)
- 17: zu temperierendes Substrat, bzw. Teil eines segmentierten Substrats
- 18: Verschraubung
- 19 ': Kollektorbereich(e)
- 20: Zuleitung Kühlmedium
- 21: Ableitung Kühlmedium, Ausströmöffnung(en)
- 22: Durchlass, Bohrung, Ausstanzung, Ausnehmung

## Patentansprüche

1. Kühlplatte (10), bestehend aus Bodenplatte (12), Aussenwänden (13) und Deckplatte (11) sowie Zuleitung (20) und Ableitung (21) für ein Kühlmedium, **dadurch gekennzeichnet, dass** zwischen Bodenplatte (12) und Deckplatte (11) einerseits punktuell Stützelemente (14) angeordnet sind, die ausgelegt sind, die mechanische Belastung zwischen Bodenplatte (12) und Deckplatte (11) aufzunehmen und ferner im wesentlichen nicht tragende Leitbleche (15), die die Unterteilung der Kühlplatte (10) in Leitbereiche (16) zulassen.

2. Kühlplatte nach Anspruch 1, **dadurch gekennzeichnet, dass** die Stützelemente (14) als Bolzen oder Hülsen ausgelegt sind.

3. Kühlplatte nach Anspruch 1-2, **dadurch gekennzeichnet, dass** die Leitbereiche vom Kühlmedium durchströmt werden.

4. Kühlplatte nach Anspruch 1-3, **dadurch gekennzeichnet, dass** die Stützelemente (14) als Hülsen die Verschraubung eines Substrats (17) durch die Kühlplatte hindurch erlauben.

5. Kühlplatte nach Anspruch 1-4, **dadurch gekennzeichnet, dass** die Stützelemente (14) nicht senkrecht zu Boden- bzw. Deckplatte angeordnet sind.

6. Kühlplatte nach Anspruch 1-5, **dadurch gekennzeichnet, dass** ferner mindestens ein Kollektorbereich (19) vorgesehen ist, der durch ein Leitblech gebildet wird, das einen Teil des Hohlkörpers (10) abtrennt und Durchlässe (22) zu anderen Leitbereichen (16) des Hohlkörpers aufweist.

7. Kühlplatte nach Anspruch 1-6, **dadurch gekennzeichnet, dass** die Kühlplatte Teil der Wandung zwischen einem Vakuumbereich und Umgebung ist.

8. Verwendung einer Kühlplatte gemäss Anspruch 1-7 in einem Kühlsystem für PVD-Sputtertargtes, Spiegeln, Wafer bzw.
Kunststoffsubstraten.

## Claims

1. Cooling plate consisting of bottom plate (12), external walls (13) and cover plate (11) as well as feed line (20) and discharge line (21) for a cooling medium, **characterized in that** between bottom plate (12) and cover plate (11), on the one hand, supporting elements (14) are arranged in a pointwise manner, which are designed for receiving mechanical strain between bottom plate (12) and cover plate (11), and furthermore essentially non-bearing guiding plates (15) allowing separation of the cooling plate (10) into guiding zones (16).

2. Cooling plate according to claim 1, (11) **characterized in that** the supporting elements (14) are designed as bolts or bushings.

3. Cooling plate according to claim 1-2, **characterized in that** the cooling medium is passed through the guiding zones.

4. Cooling plate according to claim 1-3, **characterized in that** the supporting elements (14) as bushings allow mounting a substrate (17) through the cooling plate.

5. Cooling plate according to claim 1-4, **characterized in that** the supporting elements (14) are arranged non-perpendicularly to the bottom plate and the cover plate, respectively.

6. Cooling plate according to claim 1-5, **characterized in that** furthermore there is provided at least one collector zone (19) which is formed by a guiding plate separating a portion of the hollow body (10) and having passages (22) to other guiding zones (16) of the hollow body.

7. Cooling plate according to claim 1-6, **characterized in that** the cooling plate is part of a wall between a vacuum zone and the surroundings.

8. Use of a cooling plate according to claim 1-7 in a cooling system for a PVD sputtering target, mirrors, wafers or plastic substrates.

## Revendications

1. Plaque de refroidissement consistant en une plaque de fond (12), des parois extérieures (13) et une plaque de couverture (11) ainsi qu'une conduite d'arrivée (20) et une conduite d'écoulement (21) pour un milieu de refroidissement, **caractérisé par le fait que** entre la plaque de fond (12) et la plaque de couverture (11), d'une part, des éléments de support (14) sont arrangés ponctuellement, qui sont visés à recevoir la tension mécanique entre la plaque de fond (12) et la plaque de couverture (11), et en outre sensiblement des tôles de guidage non porteurs (15) permettant la séparation de la plaque de refroidissement (10) en des zones de guidage (16).

2. Plaque de refroidissement selon la revendication 1, (11) **caractérisé par le fait que** les éléments de support (14) sont conçus en tant que des boulons ou des tiges.

3. Plaque de refroidissement selon la revendication 1-2, **caractérisé par le fait que** le milieu de refroidissement est passé à travers les zones de guidage.

4. Plaque de refroidissement selon la revendication 1-3, **caractérisé par le fait que** les éléments de support (14) permettent, en tant que des tiges, de monter un substrat (17) au travers la plaque de refroidissement.

5. Plaque de refroidissement selon la revendication 1-4, **caractérisé par le fait que** les éléments de support (14) sont arrangés non perpendiculairement à la plaque de fond et à la plaque de couverture, respectivement.

6. Plaque de refroidissement selon la revendication 1-5, **caractérisé par le fait qu'**en outre au moins une zone collectrice (19) est avisée qui est formée par une tôle de guidage séparant une partie du corps creux (10) et ayant des passages (22) menant à d'autres zones de guidage (16) du corps creux.

7. Plaque de refroidissement selon la revendication 1-6, **caractérisé par le fait que** la plaque de refroidissement fait partie d'une paroi entre une zone de vide et les environs.

8. Utilisation d'une plaque de refroidissement selon la revendication 1-7 dans un système de refroidissement pour des cibles de pulvérisation cathodique PVD, des miroirs, des plaquettes ou des substrats en matière plastique.
